# EUROPÄISCHE PATENTSCHRIFT

(11) **EP 2 250 021 B1**
(45) Veröffentlichungstag und Bekanntmachung des Hinweises auf die Patenterteilung: **04.12.2013**
(21) Anmeldenummer: 09710027.5
(22) Anmeldetag: 11.02.2009
(51) Int. Cl.: B41J 2/175

(54) **TINTENPATRONE MIT LEITERPLATTENELEMENT**
INK CARTRIDGE HAVING CIRCUIT BOARD ELEMENT
CARTOUCHE D ENCRE AVEC ÉLÉMENT DE CARTE DE CIRCUIT IMPRIMÉ

(30) Priorität: 15.02.2008 DE 102008009460
(43) Veröffentlichungstag der Anmeldung: 17.11.2010
(73) Patentinhaber: Pelikan Hardcopy Production AG, 8620 Wetzikon (CH)
(72) Erfinder: BIANCO, Lucio, CH-8645 Jona (CH); SULSER, Daniel, CH-8636 Wald (CH)
(74) Vertreter: Zech, Stefan Markus
(86) Internationale Anmeldenummer: PCT/EP2009/051549
(87) Internationale Veröffentlichungsnummer: WO 2009/101097

(56) Entgegenhaltungen:
- EP-A- 0 878 316
- EP-A- 1 219 437
- EP-A- 1 466 741
- EP-A- 1 547 782
- EP-A- 1 857 285
- US-A- 6 000 773
- US-B1- 6 227 643

## Beschreibung

Die Erfindung betrifft eine Tintenpatrone zum Einsetzen in eine Patronenaufnahme eines Tintenstrahldruckers gemäß den Oberbegriffen von Anspruch 1 sowie ein Herstellungsverfahren für eine Tintenpatrone zum Einsetzen in eine Patronenaufnahme eines Tintenstrahldruckers entsprechend Anspruch 24.

Tintenstrahldrucker gehören heutzutage zu den meist verwendeten Druckertypen, welche in vielen Heim- wie auch Büroanwendungen zum Einsatz kommen. Da Tintenstrahldrucker in ihrem Einsatz mitunter extrem häufiger Benutzung unterliegen, sind zahlreiche Bestandteile von einem starken Verschleiß betroffen, und Verschleiß- wie Verbrauchsteile müssen verhäuft ausgewechselt und ersetzt werden. Zudem erfordert die häufige Benutzung, in regelmäßigen Intervallen Wartungsarbeiten vorzunehmen. Um die Wartungsarbeiten sowie den Austausch von einzelnen Bestandteilen eines Tintenstrahldruckers zu erleichtern, werden Tintenstrahldrucker in modularer Bauweise gefertigt, wobei viele modulare Bauteile mit Mitteln versehen sind, welche den ordnungsgemäßen Austausch unterstützen bzw. eine Überprüfung des selben vornehmen lassen.

Tintenpatronen sind typischerweise die mit Abstand am häufigsten ersetzten Bestandteile bzw. Verbrauchsteile eines Tintenstrahldruckers. Zudem bedürfen Tintenpatronen auch einer verhäuften Wartung, da sowohl die Speicherung als auch die Zurverfügungstellung der im Druckprozess verwendeten Tinte ein komplexer fluidtechnischer Vorgang ist, welcher zahlreiche Fehlerquellen aufweisen kann. Die Fehlerquellen können beispielsweise von blockierten Zufuhrkanälen der Tintenpatrone bis zu fehlerhaft eingesetzten Tintenpatronen reichen. Zudem erscheint es aufgrund der großen Vielzahl an unterschiedlichen Tintenpatronen nicht abwegig, dass Benutzer beim Ersetzen von verbrauchten Tintenpatronen ein Auswechseln mit einer für das Einsetzen in eine vorgesehene Patronenaufnahme des Tintenstrahldruckers nicht geeignete Tintenpatrone vorzunehmen versuchen. Obwohl das Herausnehmen der Tintenpatrone aus der Patronenaufnahme sowie das erneute Einsetzen derselben im Prinzip eine relativ einfache Handlung darstellt, so zeigt sich in der Praxis immer wieder, dass diese Handlungen einem Benutzer mitunter große Probleme bereiten können.

Um dem Benutzer also sowohl Wartungs- als auch Austauscharbeiten im Hinblick auf die Tintenpatronen zu erleichtern, können die Tintenpatronen bereits herstellerseits mit entsprechenden elektronischen Schaltungsanordnungen versehen sein, welche nach richtigem Einsetzen in die Patronenaufnahme eines Tintenstrahldruckers über eine Steuervorrichtung des Tintenstrahldruckers angesprochen werden kann und eine Überprüfung der Funktionstüchtigkeit der Tintenpatrone vornimmt. Diese Überprüfung, welche typischerweise als elektronische Verifikationsroutine in entweder aktiver oder passiver Form abläuft, kann einem Benutzer somit die Sicherheit geben, dass eine Patrone in richtiger Art und Weise in die Patronenaufnahme des Tintenstrahldruckers eingesetzt wurde. Die Kommunikation zwischen dem Benutzer und dem Tintenstrahldrucker erfolgt dabei typischerweise über Leuchten bzw. über Mitteilungen auf einem Display am Drucker selbst. Aufgrund der örtlichen Trennung von eingesetzter Tintenpatrone und dem Wiedergabeort der Information kann es erneut zu Fehlinterpretationen bzw. Missverständnissen auf der Seite des Benutzers kommen. Aus diesem Grund haben Hersteller von Tintenstrahldruckern und Tintenpatronen zu dem konstruktionstechnischen Schritt gegriffen, die Information unmittelbar an der eingesetzten Tintenpatrone selbst darzustellen. Dem Stande der Technik bekannte Tintenpatronen, verwenden deshalb beispielsweise eigenständige Leuchteinheiten, welche dem Benutzer bei Einsetzen der Tintenpatrone in die Patronenaufnahme signalisieren, dass ein korrektes Einsetzen vorgenommen wurde. Andererseits kann auch das Ausbleiben eines Leuchtsignals an der Tintenpatrone anzeigen, dass entweder das Einsetzen in nicht richtiger Weise vorgenommen wurde, bzw. eine weitere Störung vorliegt.

Dokument US 6000 773 offenbart eine Tintenpatrone zum Einsetzen in eine Patronenaufnahme eines Tintenstrahldruckers.

Gemäß der konstruktiven Ausführung vieler Tintenpatronen von Tintenstrahldruckern sind jedoch für den Benutzer bei eingesetztem Zustand der Tintenpatrone nur ausgewählte Bereiche derselben sichtbar, und folglich geeignet, derartige Signalgeber, wie beispielsweise Leuchten oder Lampen, aufzunehmen und für den Benutzer leicht sichtbare Signale darzustellen. Die meisten Bereiche der Gehäuseeinheit einer Tintenpatrone in eingesetztem Zustand liegen für den Benutzer jedoch verborgen. Da aber andererseits konstruktionsbedingt die Schnittstelle der Tintenpatrone zu der Gegenschnittstelle der Patronenaufnahme des Tintenstrahldruckers für den Benutzer nicht einsehbar angeordnet ist, muss der optische Signalgeber der Tintenpatrone über ein Leitungssystem, ggf. über längere Distanzen, mit der Schnittstelle verbunden werden. Eine solche Verbindung, vor allem wenn Sie optischer Natur ist, kann einen konstruktionstechnischen und damit herstellungstechnischen großen Aufwand mit sich bringen und lässt die Tintenpatrone anfällig für zahlreiche Störeinflüsse werden.

Die EP 1 547 782 A2 als Druckschrift des Stand der Technik betrifft beispielsweise eine lösbar einsetzbare Tintenpatrone eines Tintenstrahldruckers, welche an einer der unteren Begrenzungsfläche der Tintenpatrone benachbart liegenden Fläche elektrische Kontakte aufweist, die zur Kontaktschließung mit entsprechenden Gegenkontakten der Patronenaufnahme des Tintenstrahldruckers vorgesehen sind. Die Kontakte sind ihrerseits auf einem eine Schaltungsanordnung aufweisenden Leiterplattenelement aufgebracht. Dieses Leiterplattenelement umfasst überdies eine lichtemittierende Diode (LED), welche zur Lichtabgabe auf dem Leiterplattenelement an dem der unteren Begrenzungsfläche benachbarten Flächenstück angeordnet ist. Um das Lichtsignal an eine für einen Benutzer bzw. einem von dem Tintenstrahldrucker umfassten Photodetektor einsehbaren Stelle zu leiten, sieht die Tintenpatrone einen im Wesentlichen an der Seitenfläche der Tintenpatrone in der Orientierung einer eingesetzten Tintenpatrone von unten nach oben gerichteten Lichtleiter vor. Das in der Nähe der oberen Begrenzungsfläche der Tintenpatrone angebrachte Endstück des Lichtleiters liegt frei und ist folglich für eine ungehinderte und detektierbare Lichtabgabe geeignet.

Das Vorsehen des Lichtleiters der Tintenpatrone gemäß der Offenbarung der EP 1 547 782 A2 birgt jedoch zahlreiche Fehlerquellen. Einerseits muss ein guter optischer Kontakt zwischen der an der Tintenpatrone angebrachten LED und dem Lichtleiter der Tintenpatrone erfolgen. Dieser kann bereits durch typische Verschmutzungen wie durch Staub oder Feuchtigkeit sowie Tinte selbst signifikant beeinträchtigt sein. Andererseits dürfen in dem Lichtleiter zur ungestörten Weiterleitung des Lichtes keinerlei Störungen wie Risse oder Brüche, wie sie etwa durch Materialermüdung nicht untypisch sind, vorliegen. Zudem müssen zu jedem Zeitpunkt die Bedingungen für das Vorliegen von Totalreflektion in dem Lichtleiter gewährleistet sein. Diese Bedingungen können jedoch bei Auftrag von Feuchtigkeit bzw. Tinte, die einem dem Brechungsindex des Lichtleiters unterschiedlichen Brechungsindex aufweist, gestört sein. Dementsprechend sind eine Reihe von typischen Störeinflüssen möglich, welche die Störungen ausgesetzte Abgabe von Licht durch die LED an eine für einen Benutzer bzw. Photodetektor einsehbare Stelle nicht immer gewährleistet sein. Zudem ist auch nur eine lineare Lichtweiterleitung vorgesehen, welche stets gerade oder plane Abschnitte an dem Gehäuse der Tintenpatrone erfordert.

Aufgabe der vorliegenden Erfindung ist es nun, die dem Stande der Technik bekannten Nachteile in einer erfindungsgemäßen Tintenpatrone zum Einsetzen in eine Patronenaufnahme eines Tintenstrahldruckers zu vermeiden, und eine Tintenpatrone vorzuschlagen, welche erlaubt, eine Signalweiterleitung, insbesondere Signale für ein optisches Signal, aus einem für den Benutzer uneinsehbaren Bereich der Tintenpatrone zu einem bei eingesetzter Tintenpatrone für den Benutzer oder eine Photodetektor einsehbaren Bereich zu ermöglichen, wobei die konstruktionsgemäße Lösung einerseits unanfällig gegenüber äußeren Störeinflüssen sein soll, und andererseits ebenso weitgehend das Weiterleiten von Signalen entlang vieler Teilbereiche der Kontur der Tintenpatrone ermöglichen soll.

Diese Aufgabe wird durch eine Vorrichtung sowie ein Verfahren zur Herstellung einer Tintenpatrone zum Einsetzen in eine Patronenaufnahme eines Tintenstrahldruckers gemäß den Patentansprüchen 1 und 24 gelöst.

Insbesondere wird die Aufgabe durch eine Tintenpatrone nach Anspruch 1 zum Einsetzen in eine Patronenaufnahme eines Tintenstrahldruckers gelöst.

Zudem wird die Aufgabe durch ein Herstellungsverfahren nach Anspruch 24 gelöst, welches sich auf eine Tintenpatrone zum Einsetzen in eine Patronenaufnahme eines Tintenstrahldruckers bezieht.

Ein wesentlicher Punkt der vorliegenden Erfindung liegt folglich darin, dass eine Signalübermittlung mittels einer Schaltungsanordnung, die von einem Leiterplattenelement umfasst wird, von einem Teilbereich des Leiterplattenelements zu einem zweiten Teilbereich des Leiterplattenelements erfolgen kann, wobei beide Teilbereiche abgewinkelt zueinander ausgerichtet sind. Es ist somit vorgesehen, die Signalübermittlung einer Schaltungsanordnung, wie sie etwa aus der elektronischen Schaltungstechnik aber auch aus der optischen Schaltungstechnik bekannt ist, über zwei Teilbereiche eines Leiterplattenelements vorzunehmen, wobei die Schaltungsanordnung wenigstens einen nicht ebenen Teilabschnitt zum Anordnen an einen ebenso nicht ebenen Abschnitt einer Tintenpatrone umfasst.

Die dem Stande der Technik bekannten Tintenpatronen umfassen zwar auch Schaltungsanordnungen auf elektronischen Platinen oder Leiterkarten. Jedoch erlauben diese aufgrund ihrer hohen Steifigkeit nicht die Signalweiterleitung bzw. Signalübermittlung über nicht ebene oder abgewinkelte Abschnitte einer Tintenpatrone. Die dem Stande der Technik bekannten Leiterkarten oder Platinen für Tintenpatronen bestehen nämlich aus einem hoch-steifen Material. Um jedoch elektrische oder auch optische Signale über abgewinkelte Abschnitte einer Tintenpatrone von einem Teilbereich der Gehäuseeinheit der Tintenpatrone zu einem anderen Teilbereich zu übermitteln, bedarf es entsprechend dem Wissen des Standes der Technik stets Schnittstellen. Derartige Schnittstellen bergen jedoch stets Fehlerquellen, welche eine störungsfreie Übermittlung eines Signals unterbinden oder jedoch merklich stören können. Entsprechend dem Kerngedanken der vorliegenden Erfindung, werden derartige Schnittstellen nun unnötig, da die Schaltungsanordnung als Ganzes, die Signalübermittlung über unebene oder abgewinkelte Abschnitte einer Tintenpatrone zwischen zwei zueinander abgewickelt ausgerichteten Teilbereichen eines Leiterplattenelements ermöglicht.

Ein zweiter Kerngedanke der vorliegenden Erfindung besteht darin, dass das Leiterplattenelement im Wesentlichen sich über eine Seitenfläche der Tintenpatrone erstreckt und auf einem der Unterseite der Tintenpatrone zugewandten zweiten Teilbereich eine Schnittstelle zur Kontaktierung zum Empfangen wie zum Versenden von Signalen bereitstellt, und auf einem der Oberseite der Tintenpatrone zugewandten weiteren Teilbereich eine lichtemittierende Diode vorsieht, welche eine optische Schnittstelle für einen Benutzer bzw. für einen von dem Tintenstrahldrucker verwendeten Photodetektor darstellt. Entsprechend der erfindungsgemäßen Konstruktion können folglich alle für die Funktion der Tintenpatrone notwendigen Schaltungsanordnungen auf einem einheitlichen Leiterplattenelement untergebracht werden, welches äußerst kostengünstig und in hohen Stückzahlen hergestellt werden kann. Da jedoch keinerlei weitere Vorkehrungen für einen Signalempfang oder eine Signalabgabe durch das Tintenpatronengehäuse getroffen werden müssen, können diese Gehäuse beispielsweise in einem sehr einfachen Spritzgussverfahren hergestellt werden. Aufwendige Verfahrensschritte, wie beispielsweise die Integration von optischen, elektronischen oder elektrischen Bestandteilen in die Gehäuseeinheit der Tintenpatrone selbst können folglich unterbleiben.

In einer bevorzugten Ausführungsform der Tintenpatrone zum Einsetzen in eine Patronenaufnahme ist vorgesehen, dass zumindest ein Teilbereich einer Außenkontur der Tintenpatrone folgend an der Tintenpatrone befestigt ist. Dieser Teilbereich kann der in einer Ebene A liegende erste Teilbereich sein, welcher beispielsweise einer planen Außenkontur der Tintenpatrone, wie sie durch Seitenwände in vielen handelsüblichen Tintenpatronen dargestellt wird, folgt. Andererseits ist es auch denkbar, dass der zweite, nicht notwendigerweise plan ausgeführte Teilbereich, welcher zum ersten Teilbereich abgewinkelt ausgerichtet ist, einer nicht planen Außenkontur der Tintenpatrone folgt, bzw. hilft, zumindest teilweise eine nicht plane Außenkontur der Tintenpatrone zu überbrücken. Die Befestigung des Leiterplattenelements kann dabei über einen oder auch über beide Teilbereiche an der Tintenpatrone erfolgen.

In einer weiterführenden Ausführungsform der vorliegenden Erfindung kann vorgesehen sein, dass die Ebene A parallel zu mindestens einer Seitenwand, vorzugsweise zu einer Vor- und/oder Rückwand, ausgerichtet ist. So kann eine Aufbringung des Leiterplattenelements auf viele handelübliche Tintenpatronen erfolgen, welche plane Seitenwände aufweisen, die wenigstens teilweise für einen Benutzer oder einen Photodetektor einsehbar angeordnet sind, auch wenn die Tintenpatrone in die Patronenaufnahme eines Tintenstrahldruckers bereits eingesetzt wurde.

In einer wiederum weiterführenden Ausführungsform der vorliegenden Tintenpatrone ist der zweite Teilbereich plan ausgebildet und liegt in einer zweiten von der Ebene A verschiedenen Ebene B. Folglich können zwei plane und jeweils zu den Ebenen A und B parallele Teilabschnitte der Tintenpatrone mit einem einheitlichen Leiterplattenelement versehen werden, ohne dass beispielsweise Schnittstellen zwischen den beiden plan ausgerichteten Teilbereichen des Leiterplattenelements vorgesehen sein müssten. Vielmehr können Leiterplattenelemente mit zwei gegeneinander abgewinkelt ausgerichteten planen Teilbereichen passgenau vorgefertigt werden, so dass diese nur noch auf vorbestimmte plane Teilabschnitte der Tintenpatrone aufgesetzt und an dieser befestigt werden müssen.

Überdies kann sich die Tintenpatrone zum Einsetzen in eine Patronenaufnahme auch dadurch auszeichnen, dass die Ebene B parallel zu einem weiteren Abschnitt der Außenbegrenzungsfläche der Tintenpatrone ausgerichtet ist. Dies ermöglicht, dass zwei plan zueinander angeordnete Teilbereiche des Leiterplattenelements in paralleler Ausrichtung an der Außenbegrenzungsfläche der Tintenpatrone aufgebracht werden, wobei lediglich ein zusammenhängendes Leiterplattenelement zwei plane und gegeneinander abgewinkelt angeordnete, benachbarte Teilabschnitte auf der Außenbegrenzungsfläche der Tintenpatrone bedecken kann.

In einer erneut weiterführenden Ausführungsform der Tintenpatrone zum Einsetzen in eine Patronenaufnahme kann vorgesehen sein, dass die Tintenpatrone Befestigungselemente aufweist, mittels welcher das Leiterplattenelement an der Tintenpatrone befestigt ist. Befestigungselemente im ausführungsgemäßen Sinne sind dabei jedwede handwerksübliche mechanische sowie auch auf Adhäsion beruhende Befestigungselemente. Durch das Vorsehen der Befestigungselemente in der Konstruktion des Gehäuses der Tintenpatrone kann ein Leiterplattenelement, welches zur Verbindung mit der Tintenpatrone vorgesehen ist, selbst eine einfache, beispielsweise rechteckige, Form aufweisen. Dieser Umstand unterstützt wiederum die Herstellung von Leiterplattenelementen in großer Stückzahl sowie mittels der industriebekannten Herstellungsverfahren. Alternativ hierzu ist das Vorsehen von besonderen Verankerungsstrukturen in dem Leiterplattenelement ebenso denkbar, doch verursacht dieses in den meisten Herstellungsverfahren zur Produktion größerer Mengen an Leiterplattenelementen weitere Verfahrensschritte und damit Kosten.

In einer weiterführenden Ausführungsform der vorliegenden Tintenpatrone kann sich diese durch eine Laufschiene auszeichnen, insbesondere an der mindestens einen Seitenwand, zum Einführen wenigstens eines Teiles des Leiterplattenelements. Laufschienen sind einfache mechanische Konstruktionsmittel, durch welche in einem Verbindungsschritt, nämlich dem Einschieben des Leiterplattenelements in die Laufschiene, eine relativ feste und haltbare Verbindung zwischen Tintenpatrone und Leiterplattenelement hergestellt werden kann. Die Laufschiene kann konstruktionsgemäß bereits in der Gehäuseeinheit der Tintenpatrone vorgesehen sein, oder aber erst nachträglich in einem separaten Herstellungsschritt auf diese aufgebracht werden. Laufschienen erlauben zudem eine Verbindung von Tintenpatrone und Leiterplattenelement ohne, dass weitere Befestigungsmethoden notwendig würden. Zudem kann die ausführungsgemäße Laufschiene, welche alternativ auch durch eine Mehrzahl von Laufschienen ersetzt sein kann, derart auf der Tintenpatrone angeordnet sein, dass nach Einführen eines Teils des Leiterplattenelements die Führungskräfte der Laufschiene auf das Leiterplattenelement derart gerichtet sind, dass sie möglichen Beanspruchungen des Leiterplattenelements durch die Benutzung oder Handhabung der Tintenpatrone eine gute Haltekraft entgegensetzen.

Weiterhin kann vorgesehen sein, dass die Befestigungselemente einen elastisch verformbaren Verriegelungshaken umfassen. Der Verriegelungshaken kann alternativ oder auch zusätzlich zu weiteren Befestigungselementen vorgesehen sein. Er kann wiederum fester Bestandteil der Tintenpatrone bzw. der Gehäuseeinheit der Tintenpatrone sein, oder aber erst nachträglich in einem separaten Herstellungsschritt an dieser angebracht werden. Der Verriegelungshaken kann dabei derart ausgeführt wie auch an der Tintenpatrone derart angebracht sein, dass er in vorbestimmte Bereiche des Leiterplattenelements eingreift, bzw. diese mit einer Verriegelungskraft beaufschlagt, so dass das Leiterplattenelement mit der Tintenpatrone verbunden wird. Ebenso ist es möglich, einen Verriegelungshaken in Kombination mit einer Laufschiene zur Befestigung des Leiterplattenelements an der Tintenpatrone vorzusehen. Hierzu wäre es denkbar, dass das Leiterplattenelement zunächst wenigstens teilweise in die Laufschiene eingeführt wird, wobei der Verriegelungshaken nach erfolgter Einführung das Leiterplattenelements dieses verriegelt und folglich an der Tintenpatrone befestigt. Der Verriegelungshaken kann hierbei entweder eine der Seitenbegrenzungen des Leiterplattenelements mit einer Haltekraft beaufschlagen oder aber in vorbestimmte Aussparungen bzw. geeignete Formteilbereiche des Leiterplattenelements eingreifen und diese mit einer entsprechenden Haltekraft beaufschlagen. Ebenso wäre es denkbar, dass das Leiterplattenelement durch eine Mehrzahl an Verriegelungshaken an der Tintenpatrone befestigt wird, welche in einer aufeinander abgestimmten Weise so das Leiterplattenelement mit Haltekräften beaufschlagen, dass eine ausreichende Befestigung an der Tintenpatrone erfolgt.

In einer weiterführenden Ausführungsform der vorliegenden Erfindung kann vorgesehen sein, dass das Leiterplattenelement an der Tintenpatrone lösbar angebracht ist. Daraus resultiert einerseits, dass bei Vorliegen eines fehlerhaften Leiterplattenelements dieses lediglich in der Tintenpatrone ausgetauscht werden muss, um eine möglicherweise weiterhin verwend- bzw. verkaufbare Tintenpatrone zu erzeugen. Darüber hinaus erlaubt die lösbare Anbringung des Leiterplattenelements an der Tintenpatrone die Herstellung beider Bestandteile in jeweils separaten und deswegen möglicherweise kostengünstigeren üblichen Herstellungsschritten. Zudem eröffnet die lösbare Anbringung des Leiterplattenelements die Möglichkeit, ein vereinfachtes Recycling der Tintenpatrone zusammen mit dem Leiterplattenelement auszuführen, welches gerade im Lichte der zukünftigen Verantwortung der Hersteller von Tintenpatronen einen erfreulichen Umstand bedeutet. Denn anders als bei Tintenpatronen die Leiterplattenelemente beispielsweise in integrierter oder eingegossener Form aufweisen und damit im späteren Recycling mitunter aufwendige Trennungsschritte erfordern, kann gemäß der vorliegenden Ausführungsform das Leiterplattenelement einfach von der Tintenpatrone gelöst und separat entsorgt werden.

In einer weiterführenden Ausführungsform der Tintenpatrone kann das Leiterplattenelement an der Tintenpatrone mittels Verklebung oder Laminierung oder Einschmelzung angebracht sein. Diese industrieüblichen Befestigungsverfahren, welche eine hohe Festigkeit der Verbindung von Leiterplattenelement und Tintenpatrone gewährleisten, können relativ unkompliziert vorgenommen werden. Zudem kann eine dauerhafte und unter allen Betriebsbedingungen feste Anbringung des Leiterplattenelements an der Tintenpatrone gewährleistet werden. Durch diese feste, praktisch nicht reversible Verbindung von Leiterplattenelement und Tintenpatrone wird zudem verhindert, dass Unberechtigte das Leiterplattenelement leicht von der Tintenpatrone entfernen und ungestört manipulieren. In Bezug auf eine Verklebung des Leiterplattenelements mit der Tintenpatrone können alle handels- und industrieüblichen Kleber Verwendung finden, soweit diese geeignet sind, die zur Verbindung vorgesehenen Flächen miteinander zu verkleben.

Die Aufgabe wird auch durch ein Leiterplattenelement zur Verbindung mit eine Tintenpatrone nach Anspruch 11 gelöst.

Folglich vermag das Leiterplattenelement auch in Verbindung mit Tintenpatronen eingesetzt zu werden, deren Außenkontur nicht lediglich einen planen Flächenabschnitt aufweist. Entsprechend der vorliegenden Ausführungsform kann das Leiterplattenelement vielmehr auf gekrümmte Flächenabschnitte oder aber auch auf gegeneinander in einer Schrägung verlaufende Flächenabschnitte angebracht werden. Eine Schrägung im vorliegenden Sinne ist ein nichtplaner, zusammenhängender Bereich, welcher zwei im Wesentlichen plane - zumindest lokal plane - und aneinander grenzende Abschnitte oder Flächenabschnitte aufweist deren gegenseitige Orientierung einen Grenzwinkel von ungleich 180° ausweisen. Der Grenzwinkel seinerseits ist definiert als der Winkel zwischen den Abschnitt- oder Flächenabschnittnormalen.

Der Biegebereich, welcher vorzugsweise flexibel ausgestaltet ist, erlaubt somit eine anpassbare Anbringung des Leiterplattenelements an nicht planare Abschnitte der Tintenpatrone, indem ein Teilbereich des Leiterplattenelements zunächst an der Tintenpatrone angebracht wird und der weitere Teilbereich nach einem Biegevorgang des Biegebereichs so an die Außenkontur der Tintenpatrone hingeführt wird, dass auch er an der Tintenpatrone bzw. parallel dazu befestigt werden kann. Zudem erlaubt das Vorsehen eines Biegebereiches des Leiterplattenelementes auch eine flexible Anpassung an unterschiedliche Teilbereiche voneinander verschiedener Tintenpatronen. Demzufolge kann ein ausführungsgemäßes Leiterplattenelement mitunter auch für eine Serie an unterschiedlichen Tintenpatronen vorgesehen sein ohne eines in seiner Konstruktion abweichendes Leiterplattenelements zu bedürfen. Die unmittelbare Folge davon ist eine Einsparnis von konstruktiven, herstellungstechnischen sowie auch wirtschaftlichen Aufwendungen.

Weiterhin ist es möglich, dass das Leiterplattenelement zur Verbindung mit einer Tintenpatrone so ausgeführt ist, dass der Verbindungsabschnitt Leiterbahnen umfasst. Die Leiterbahnen als Bestandteil der Schaltungsanordnung, welche von dem Leiterplattenelement umfasst wird, erlauben ausführungsgemäß eine direkte Verbindung des ersten sowie des zweiten Teilbereiches des Leiterplattenelements, ohne dass diese miteinander direkt aneinander angrenzend verbunden sein müssen. Leiterbahnen, wie beispielsweise in einem photolithographischen Verfahren mit einem nachfolgenden Ätzverfahren hergestellt, zeichnen sich durch große Flexibilität aus. Demnach ist es nicht ungewöhnlich, dass Leiterbahnen auch auf flexiblem Substrat aufgebracht werden können, ohne die Intaktheit der Schaltungsanordnung, von welcher die Leiterbahnen umfasst werden, zu gefährden. Vorliegend ist somit auch eine vorteilhafte Verbindungskonstruktion beider Teilbereiche unter Ausnutzung aller Vorzüge der beschriebenen Leiterbahnen möglich. Ausführungsgemäß sind die Leiterbahnen zudem nicht auf ausschließlich elektrische bzw. elektronische Leiterbahnen beschränkt. Vielmehr sind ebenso flexible optische Leiterbahnen denkbar, wenn diese die Anforderungen an Flexibilität des Verbindungsabschnittes erfüllen.

In einer erneut weiterführenden Ausführungsform des vorliegenden Gegenstandes kann der zweite Teilbereich des Leiterplattenelements Kontaktelemente aufweisen, welche bei in die Patronenaufnahme des Tintenstrahldruckers eingesetzter Tintenpatrone mit entsprechenden Gegenkontaktelementen der Patronenaufnahme des Tintenstrahldruckers einen elektrischen Kontakt schließen können. Dementsprechend stellen die Kontaktelemente die Schnittstelle zu der wenigstens einen Schaltungsanordnung auf dem Leiterplattenelement dar. Die Kontaktelemente sind vorzugsweise derart geformt, dass sie der Geometrie der Gegenkontaktelemente spiegelbildlich entsprechen. Die Kontaktelemente des zweiten Teilbereichs können als herkömmliche elektrische Kontakte ausgebildet sein, oder aber als optische Kontaktelemente zum Übermitteln von optischen Signalen.

Alternativ kann das Leiterplattenelement auch eine größere Anzahl an aufeinander folgende Schichten umfassen. Die Schaltungsanordnung kann in einem solchen Fall dann beliebig auf einer für sie geeigneten Schicht angeordnet sein. Derartige Schichtreihenfolgen entstehen typischerweise bei photolithographischen Verfahren zur Darstellung von Schaltungsanordnungen mittels einer Reihe chemischer und physikalischer Schritte. Typischerweise wird hierbei auf einer oberflächlichen Schicht eines Leiterplattenelementrohlings eine Abbildung der Schaltungsanordnung mittels photographischer Ablichtung aufgetragen und durch einen Ätzprozess entwickelt. Die ausführungsgemäß dem Leiterplattenelement Festigkeit verleihende zweite Schicht kann ein beliebiges Material von entsprechender Steifigkeit und Festigkeit aufweisen. Typische geeignete Materialien sind Kunststoffe oder Harze aller Art. Für elektrische oder elektronische Schaltungsanordnungen ist es darüber hinaus auch wichtig, dass die dem Leiterplattenelement Festigkeit verleihende zweite Schicht auch isolierende Eigenschaften aufweist. Im Falle des Vorsehens einer rein optischen Schaltungsanordnung sind derartige Einschränkungen nicht zwingend notwendig.

Der Verbindungsabschnitt weist nicht die durch die zweite Schicht verliehene vollständige Festigkeit auf, und hat beispielsweise im Vergleich zu den anderen Teilbereichen des Leiterplattenelements eine höhere Flexibilität gegen Verbiegung. Durch das Verdünnen der zweiten Schicht in dem Verbindungsabschnitt, kann somit durch entsprechende Wahl der Schichtdicke die Flexibilität bzw. die Biegesteifigkeit des Verbindungsabschnittes variabel gestaltet werden. Zudem können durch eine entsprechende Ausgestaltung der Verdünnung des Verbindungsabschnittes weitere Bereiche des Leiterplattenelements geschaffen werden, in welche Befestigungselemente der Tintenpatrone eingreifen können bzw. diese mit einer Haltekraft beaufschlagen.

Das Leiterplattenelement zur Verbindung mit einer Tintenpatrone kann in einer weiteren Ausführungsform auch vorsehen, dass die dem Leiterplattenelement Festigkeit verleihende zweite Schicht im Verbindungsabschnitt entfernt ist. Dementsprechend wird der Verbindungsabschnitt lediglich von der ersten Schicht gebildet, welche Teile der Schaltungsanordnung umfassen kann. Durch Entfernen der zweiten Schicht wird die Stabilität sowie Flexibilität des Verbindungsabschnittes vollständig durch die erste Schicht bestimmt. Dieser Umstand mag bei unsachgemäßer Handhabung des Leiterplattenelements zu einer unachtsamen Schädigung des Leiterplattenelements beitragen, diese Nachteile werden jedoch aufgewogen durch die herstellungstechnischen Vorteile, welche sich durch ein einfaches Entfernen der zweiten Schicht im Verbindungsabschnitt ergeben.

In einer weiteren Ausführungsform des Leiterplattenelements zur Verbindung mit einer Tintenpatrone kann dieses weitere Kontaktpunkte aufweisen, welche zur Kontaktierung mit einer externen elektrischen Schnittstelle vorgesehen sind, über welche nach Herstellung eines elektrischen Kontaktes Informationen oder Signale zu der auf der ersten Schicht angeordneten Schaltungsanordnung gesendet oder mit dieser ausgetauscht werden können. Über derartige Kontaktpunkte können beispielsweise Betriebsparameter der Schaltungsanordnung mit einem externen Lesegerät bei Bedarf ausgelesen werden. Weitaus relevanter ist jedoch, über die Kontaktpunkte programmierbare Schaltungselemente der Schaltungsanordnung mit Information zu versorgen und diese entsprechend vorbestimmter Informationen für die Bereitstellung einer spezifischen Funktionalität der Leiterplatte und der Tintenpatrone zu programmieren. So können beispielsweise die Tintenpatrone charakterisierende physikalische oder logistische Parameter auf das Leiterplattenelement eingelesen werden, welche zur Identifikation der Tintenpatrone bzw. zu deren Status anderweitig ausgelesen bzw. steuerungstechnisch verarbeitet werden können. Um möglicherweise ein versehentliches Beschreiben bzw. Löschen von Informationen zu verhindern, können Kontaktpunkte vorgesehen sein, über welche lediglich ein Auslesen von Information möglich ist. Andere Kontaktpunkte hingegen können beispielsweise spezifisch für die Programmierung der Schaltungsanordnung des Leiterplattenelementes vorgesehen sein. Das Vorsehen von weiteren Kontaktpunkten auf dem Leiterplattenelement zum Senden oder Austauschen von Information oder Signalen mit der Schaltungsanordnung erlaubt folglich ein breites Spektrum an Möglichkeiten zur Individualisierung des Leiterplattenelements für eine Tintenpatrone mit verbesserter Funktionalität.

In einer anderen Ausführungsform des vorliegenden Erfindungsgegenstandes kann zudem vorgesehen sein, dass das Leiterplattenelement wenigstens eine lichtemittierende Diode (LED) aufweist. Durch das Vorsehen von wenigstens einer lichtemittierenden Diode als Schaltungselement der Schaltungsanordnung wird die Funktionalität des die lichtemittierende Diode umfassenden Leiterplattenelementes dahingehend erhöht, dass nach entsprechenden Steuersignalen der Schaltungssteuerung Lichtsignale nach außen zur Beobachtung durch einen Benutzer bzw. zur Aufnahme durch einen Photodetektor abgegeben werden. Dementsprechend kann sich ein Benutzer bzw. eine mit einem Photodetektor zusammenwirkende Steuervorrichtung mittels wahrgenommener Lichtsignale vordefinierte Schaltungszustände der Schaltungsanordnung auf dem Leiterplattenelement wahrnehmen. Die durch vorbestimmte Steuersignale der Schaltungsanordnung veranlassten Lichtsignale der lichtemittierenden Diode können bei geeigneter Steuerung Auskunft über Funktionszustände der Tintenpatrone, Störzustände oder auch für die Wartung der Tintenpatrone relevante Lichtsignale abgeben. Demzufolge wird die Wartungsfähigkeit erhöht sowie die direkte Überprüfbarkeit des Funktionszustandes der Tintenpatrone ermöglicht.

Gemäß einer weiteren Ausführungsform der vorliegenden Tintenpatrone zum Einsetzen in eine Patronenaufnahme kann vorgesehen sein, dass die Kontaktelemente im Wesentlichen endständig auf dem zweiten Teilbereich des Leiterplattenelements angeordnet sind. Die endständige Anordnung erleichtert entsprechend die Kontaktherstellung der Kontaktelemente mit in der Patronenaufnahme umfassten Gegenkontaktelementen. Außerdem vermeidet eine endständige Anordnung der Kontaktelemente das Vorsehen unnötiger Flächenabschnitte des Leiterplattenelements.

Das Leiterplattenelement kann weiterhin vorsehen, dass wenigstens eine lichtemittierende Diode (LED) auf dem ersten Teilbereich des Leiterplattenelements angeordnet ist. Folglich kann die wenigstens eine lichtemittierende Diode unabhängig von der Ausrichtung des zweiten Teilbereichs des Leiterplattenelements Licht mit einer Vorzugsrichtung in Bezug auf den ersten Teilbereich abstrahlen. Die Richtung der Lichtabstrahlung ist damit unabhängig vom zweiten Teilbereichen des Leiterplattenelements und dessen Orientierung.

In einer weiterführenden Ausführungsform des Leiterplattenelements zur Verbindung mit einer Tintenpatrone kann vorgesehen sein, dass wenigstens eine lichtemittierende Diode (LED) im Wesentlichen endständig auf dem ersten Teilbereich des Leiterplattenelements angeordnet ist. Für den Fall, dass das von.der lichtemittierenden Diode abgestrahlte Licht von einem Photodetektor abgegriffen wird und einer weiteren Steuervorrichtung bzw. Registriervorrichtung zugeführt wird, erlaubt die endständige Anordnung der lichtemittierenden Diode einen relativ ungestörten Abgriff. Zudem wird der Abgriff von einem größeren Raumwinkelbereich aus ermöglicht. Letzteres ist auch für einen Benutzer zutreffend, der das Licht der lichtemittierenden Diode aus einen größeren Raumwinkelbereich im Bezug auf den ersten Teilbereich beobachten kann.

In einer weiterführenden Ausführungsform des Leiterplattenelements zur Verbindung mit einer Tintenpatrone ist vorgesehen, dass wenigstens eine lichtemittierende Diode (LED) auf dem Leiterplattenelement derart angeordnet ist, dass das von der lichtemittierenden Diode (LED) bei Aktivierung abgestrahlte Licht ungehindert von der Tintenpatrone, insbesondere senkrecht zu der Ebene A des Leiterplattenelements abgestrahlt wird. Dementsprechend ist es möglich, mittels weiterer technischer Vorkehrungen, wie beispielsweise einem Photodetektor, das von der lichtemittierenden Diode abgestrahlte Licht in ungehinderter Intensität zu detektieren und das detektierte Signal möglicherweise in einem weiteren Steuerungsprozess zu verarbeiten. Darüber hinaus erleichtert die ungehinderte Abstrahlung des Lichtes der lichtemittierenden Diode die optische Wahrnehmung durch einen Benutzer, der das Licht in seiner vollen Intensität wahrnehmen kann.

Darüber hinaus kann vorgesehen sein, dass die Schaltungsanordnung des Leiterplattenelements geeignet ist, die von einer externen Steuerung des Tintenstrahldruckers über die Kontaktelemente empfangenen Signale zu verarbeiten, und auf entsprechende Aufforderung eine Verifikationsroutine auszuführen, welche eine Verifikation der mit dem Leiterplattenelement verbundenen Tintenpatrone erlaubt. Die Schaltungsanordnung ist folglich konstruiert, um mittels einer Verifikationsroutine überprüfen zu können, ob eine richtige Tintenpatrone in korrekter Weise in die Patronenaufnahme des Tintenstrahldruckers eingesetzt wurde und auch zum Drucken bereitsteht. Verifikationsroutinen dieser Art können darüber hinaus noch weitere Testalgorithmen umfassen, welche auch andere Aspekte der Funktionstätigkeit der Tintenpatrone, wie beispielsweise den Füllstand, überprüfen.

In einer Weiterführung der Tintenpatrone kann zudem vorgesehen sein, dass nach Durchlaufen der Verifikationsroutine die Schaltungsanordnung die Abgabe eines Lichtsignals durch die lichtemittierende Diode (LED) auf dem Leiterplattenelement erlaubt. Auf diese Weise kann beispielsweise dem Benutzer zu erkennen gegeben werden, dass eine bestimmte Tintenpatrone einen vorbestimmten Funktions- oder Testzustand erreicht hat. Je nach Signalabgabe mit Signalen vorbestimmter Signalkennungen kann dem Benutzer eine positive wie auch negative Rückmeldung vermittelt werden. Zudem ist es auch denkbar, dass Signale bestimmter Kennungen auch einen spezifischen Funktionszustand anzeigen, welcher nicht lediglich nur die Druckbereitschaft der Tintenpatrone anzeigt. Folglich können auch Signale im Hinblick auf aktuelle Füllstandszustände der Tintenpatrone bzw. Funktionszustände des mit der Tintenpatrone zusammenwirkenden Druckkopfes übermittelt werden.

Alternativ hierzu ist auch möglich, dass nach Durchlaufen der Verifikationsroutine, die Schaltungsanordnung die Abgabe eines Lichtsignals durch die lichtemittierende Diode (LED) auf dem Leiterplattenelement verhindert, falls das Ergebnis der Verifikationsroutine negativ ausgefallen ist. Dementsprechend beinhaltet auch ein Ausbleiben eines möglicherweise von dem Benutzer erwarteten Lichtsignals Information über die Funktionstätigkeit bzw. den Funktionszustand der Tintenpatrone. Ein Benutzer erwartet nämlich beispielsweise nach erfolgreichem Einsetzen einer Tintenpatrone in die Patronenaufnahme des Tintenstrahldruckers, dass die Funktionstüchtigkeit der Tintenpatrone in all ihren Funktionen klar durch ein oder mehrere Lichtsignale zu erkennen gegeben wird. Fällt hingegen das Lichtsignal unerwarteterweise aus, wird dem Benutzer zu erkennen geben, dass entweder die Funktionstüchtigkeit der Tintenpatrone nicht gegeben ist oder aber ein weiteres Problem im Hinblick auf eine ungestörte Funktionstüchtigkeit der Tintenpatrone vorliegt.

Weitere Ausführungsformen der Erfindung ergeben sich aus den Unteransprüchen.

Nachfolgend wird die Erfindung anhand von Ausführungsbeispielen beschrieben, welche mittels der Abbildungen näher erläutert werden.

Hierbei zeigen:
- Fig. 1: eine Ausführungsform der erfindungsgemäßen Tintenpatrone zum Einsetzen in eine Patronenaufnahme eines Tintenstrahldruckers in perspektivischer Seitenansicht,
- Fig. 2: die Tintenpatrone zum Einsetzen in eine Patronenaufnahme gemäß Fig. 1 in einer Seitenansicht,
- Fig. 3: die Tintenpatrone zum Einsetzen in eine Patronenaufnahme gemäß der vorhergehenden Figuren in einer Frontansicht,
- Fig. 4: eine Ausführungsform des erfindungsgemäßen Leiterplattenelements zur Verbindung mit einer Tintenpatrone in einer flächigen Aufsicht von oben,
- Fig. 5: das Leiterplattenelement zur Verbindung mit einer Tintenpatrone gemäß Fig. 4 in einer Seitenansicht, und
- Fig. 6: das in Fig. 5 und Fig. 4 dargestellte Leiterplattenelement zur Verbindung mit einer Tintenpatrone, gegeneinander abgewinkelten ersten und zweiten Teilbereich des Leiterplattenelements.

In der nachfolgenden Beschreibung werden für gleiche oder gleichwirkende Teile dieselben Bezugszeichen verwendet.

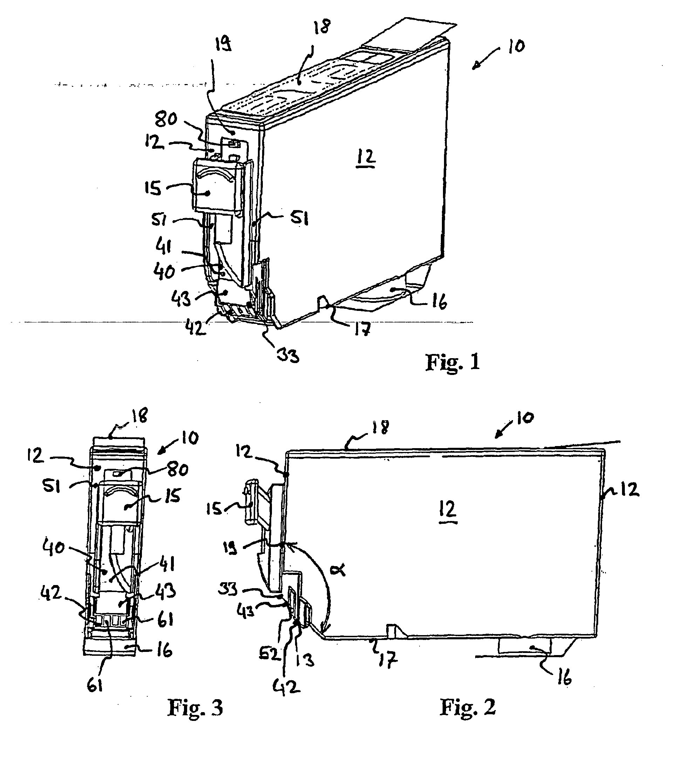

Fig. 1 zeigt eine Ausführungsform der erfindungsgemäßen Tintenpatrone zum Einsetzen in einen Patronenaufnahme eines Tintenstrahldruckers, der Gehäuse im Wesentlichen quaderförmig konstruiert ist. Das Gehäuse der Tintenpatrone 10 umfasst insgesamt vier Seitenwände 12, von welchen aufgrund der perspektivischen Darstellung lediglich eine Vorderwand 19 als auch eine an diese Vorderwand 19 anschließende großflächige Seitenwand 12 gezeigt sind. Beide Seitenwände 12 werden entsprechend der vorliegenden Orientierung der Tintenpatrone nach oben hin durch die Oberseite 18 und nach unten hin durch die Unterseite 17 begrenzt und sind mit diesen verbunden. Alle Seitenwände 12 zusammen mit der Unterseite 17 und der Oberseite 18 definieren ein Tintenpatronenvolumen, in welchem die Tinte für den Druckvorgang gespeichert ist.

Ferner umfasst die Tintenpatrone den Arretierverschluss 15, welcher beim Einsetzen der Tintenpatrone 10 in eine nicht weiter gezeigte Patronenaufnahme des Tintenstrahldruckers die Tintenpatrone in der Patronenaufnahme fest verriegelt und somit ein unbeabsichtigtes Lösen der Tintenpatrone 10 aus der Patronenaufnahme verhindert.

Weiterhin umfasst die Tintenpatrone 10 an der Vorderwand 19 eine Laufschiene 51, welche sich in der dargestellten Orientierung der Tintenpatrone am rechten und linken Außenrand der Vorderwand 19 von unten nach oben erstreckt. Dementsprechend wird die Laufschiene 51 durch zwei in das Gehäuse der Tintenpatrone 10 integrierte Nuten gebildet, welche sich an den rechten und linken Außenrändern der Vorderwand 19 wie beschrieben erstrecken und erlauben, ein Leiterplattenelement 40 von unten nach oben in die Nuten einzuführen, um das Leiterplattenelement 40 an der Tintenpatrone 10 zu befestigen. Das Leiterplattenelement 40 befindet sich vorliegend über die ganze Länge der Laufschiene 51 in diese eingeführt, wobei eine weitere Einführung des Leiterplattenelements 40 nach oben durch ein Stoppelement, wie beispielsweise einem Materialvorsprung aus der Vorderwand 19 oder wie vorliegend durch einen Quersteg, welcher die beiden die Laufschiene 51 erzeugenden Nuten nach oben zur Oberseite 18 hin verbindet, verhindert ist. Das Leiterplattenelement 40 ist vorliegend im Wesentlichen über die gesamte Höhenerstreckung des ersten Teilbereiches 41 (gemäß der vorliegend dargestellten Orientierungen) in die Laufschiene 51 eingeführt. Der zweite Teilbereich 42 des Leiterplattenelements befindet sich vorliegend an einem Abschnitt der Tintenpatrone 10 angeordnet, welcher die im Wesentlichen im rechten Winkel zueinander liegende Vorderwand 19 und Unterseite 17 schräg verbindet. Durch diesen Abschnitt zusammen mit der Vorderwand 19 wird eine Schrägung 33 im weiter oben definierten Sinne ausgebildet.

Die Schrägung, welche durch den bezeichneten Abschnitt zusammen mit der Vorderwand 19 geformt wird, ist besonders gut in Fig. 2 zu erkennen. Hierbei ist jedoch auch zu erkennen, dass der bezeichnete Abschnitt, welcher die im Wesentlichen senkrecht zueinander liegenden Vorderwand 19 und Unterseite 17 der Tintenpatrone 10 verbindet, nicht im Sinne eines durchgehenden oder auch nur planen Flächenabschnittes zu verstehen ist. Vielmehr weist der Abschnitt nur bereichsweise plane und durchgehende Flächenabschnitte auf, welche jedoch untereinander über die Gehäusestruktur der Tintenpatrone 10 verbunden sind und dafür ausgebildet sind, den zweiten Teilbereich 42 des Leiterplattenelements aufzunehmen bzw. zu befestigen. Die Befestigung des Leiterplattenelements 40 erfolgt vorliegend durch einen Verriegelungshaken 52, welcher in eine dafür bestimmte Vertiefung zwischen dem zweiten Teilbereich 42 und dem Verbindungsabschnitt 43 eingreift. Das Leiterplattenelement 40 wird demnach gegen ein unbeabsichtigtes Lösen aus der Laufschiene 51 nach unten (entsprechend der vorliegend dargestellten Orientierungen) mittels des Verriegelungshakens 52 gesichert, welcher das Leiterplattenelement 40 mit einer entsprechenden Haltekraft beaufschlagt.

Fig. 3 zeigt eine Frontansicht der Tintenpatrone 10 in welcher die vorliegenden Proportionen des Leiterplattenelements 40 als auch der Laufschiene 51 noch einmal deutlicher dargestellt werden. Gut zu erkennen ist, dass der zweite Teilbereich 42 des Leiterplattenelements 40 insgesamt vier Kontaktelemente 61 aufweist, über welche die auf dem Leiterplattenelement 40 vorhandene Schaltungsanordnung 55 (vorliegend nicht gezeigt) mit einer nicht weiter dargestellten Schnittstelle der Patronenaufnahme des Tintenstrahldruckers kommunizieren kann. Vorliegend sind lediglich zwei der Kontaktelemente 61 mit Bezugszeichen versehen, um die Klarheit der Darstellung nicht zu stören.

Der zweite Teilbereich 42 ist konstruktionsgemäß mit dem ersten Teilbereich 41 über den Verbindungsabschnitt 43 verbunden. Der erste Teilbereich 41 befindet sich vollständig über seine gesamte vorliegend dargestellte Höhenausdehnung in die Laufschiene 51 eingeführt. Deutlich zu sehen sind die an der Vorderwand 19 rechts und links jeweils angebrachten Nuten der Laufschiene 51, welche die seitlichen Abschlussränder des Leiterplattenelements 40 umfassen und folglich das Leiterplattenelement 40 an der Vorderwand 19 fixieren.

Das Leiterplattenelement 40 wurde vorliegend in die Laufschiene 51 derart eingeführt bzw. von dieser derart befestigt, dass eine lichtemittierende Diode (LED) 80 am oberen Rand des Vorderwand 19 liegt. Die lichtemittierende Diode 80 ist derart positioniert, dass sie einerseits in Bezug auf eine auf die Vorderwand 19 senkrechte Sichtlinie nicht von dem Arretierverschluss 15 überdeckt wird, andererseits auch nicht von der die Vorderwand 19 nach oben abschließende Quersteg, welcher die beiden rechts und links an der Vorderwand 19 angeordneten Nuten der Laufschiene 51 verbindet.

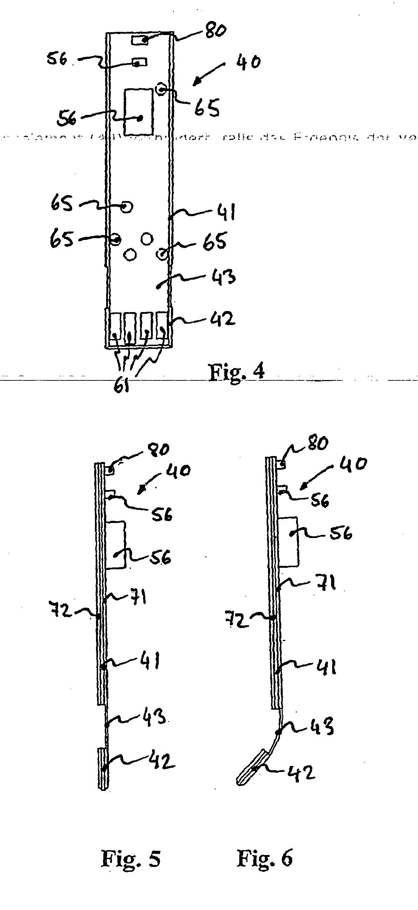

Fig. 4 zeigt eine Aufsicht des in die Tintenpatrone gemäß Fig. 1 bis 3 eingesetzten Leiterplattenelements 40. Das Leiterplattenelement 40 weist eine Dreiteilung in ersten Teilbereich 41, zweiten Teilbereich 42 sowie einen beide Teilbereiche 41 und 42 verbindenden Verbindungsabschnitt 43 auf. Die Erstreckung des zweiten Teilbereiches 42 von oben nach unten (entsprechend der vorliegenden Darstellung) entspricht in etwa der Höhenausdehnung des Verbindungsabschnittes 43. Die Höhenausdehnung des vorliegend dargestellten zweiten Teilbereiches 42 sowie des Verbindungsabschnittes 43 sind jedoch deutlich kleiner als die Höhenerstreckung des ersten Teilbereiches 41. Alle drei vorliegend dargestellten Teilbereiche bzw. Abschnitte umfassen auf der dem Betrachter zugewandten Seite eine Schaltungsanordnung 55, welche vorliegend jedoch nicht im Detail gezeigt und deswegen nicht mit Bezugszeichen versehen ist. Dennoch sind Schaltungselemente 56, welche auf dem ersten Teilbereich 41 angeordnet sind, deutlich zu erkennen. Hierbei kann es sich entsprechend einer konkreten Ausführung des Leiterplattenelements 40 beispielsweise um klassische Schaltungselemente wie Widerstände, Kondensatoren oder Schaltungsbrücken handeln, jedoch auch Halbleiterschaltelemente oder integrierte Schaltungselemente können vorgesehen sein.

Die vorliegende Schaltungsanordnung 55 sendet bzw. empfängt Informationen und Signale über die Kontaktelemente 61, welche die auf das Leiterplattenelement 40 bezogene elektrische Schnittstelle darstellen. Die Kontaktelemente 61 können mit vorliegend nicht weiter dargestellten Gegenkontaktelementen einer Patronenaufnahme eines Tintenstrahldruckers kontaktiert werden, und folglich von der Steuerungsvorrichtung des Tintenstrahldruckers angesprochen werden bzw. Signale an diese versenden. Die Kontaktelemente 61 sind vorliegend auf der dem Betrachter zugewandten Seite des zweiten Teilbereiches 42 angeordnet, welcher, wie in den vorhergehenden Figuren zu erkennen ist, nach entsprechender Befestigung des Leiterplattenelements 40 an der Tintenpatrone 10 an dem Abschnitt der Tintenpatrone angebracht ist, welcher die Vorderwand 19 mit der Unterseite 17 der Tintenpatrone 10 über eine Schrägung 33 verbindet. Die vorliegend in Figur 2 für die Anbringung des Leiterplattenelements 40 an die Tintenpatrone 10 relevante Schrägung umfasst in der in Figur 2 dargestellten Seitenansicht einen Winkel α von etwa 135°.

Weitere Elemente der Schaltungsanordnung 55 sind die Kontaktpunkte 65, welche auf dem ersten Teilbereich 41 des Leiterplattenelements 40 angeordnet sind. Hierbei sind insgesamt sechs Kontaktpunkte 65 dargestellte, welche in keinem unmittelbar erkennbaren geometrischen Verhältnis zueinander stehen. Die Anordnung der Kontaktpunkte 65 erlaubt zum einen aufgrund des Fehlens einer regelmäßigen Anordnung die sichere Erkennung und Identifizierung eines vorbestimmten Kontaktpunktes 65. Außerdem ist es möglich, dass die Anordnung der Kontaktpunkte 65 so erfolgt, dass sie mit einer externen Schnittstelle mit entsprechend angeordneten Gegenkontaktpunkten bequem abgegriffen werden können.

Weiterhin umfasst das Leiterplattenelement 44 eine lichtemittierende Diode 80, welche am oberen (entsprechend vorliegender Darstellung) Abschlussrand des Leiterplattenelements 40 im ersten Teilbereich 41 angeordnet ist. Entsprechend dieser Anordnung wird es der lichtemittierenden Diode 80 ermöglicht, wie auch bereits unter Fig. 3 erläutert, in Bezug auf eine senkrecht zur dargestellten Oberfläche des ersten Teilbereichs 41 verlaufende Sichtlinie, Licht ungestört abzustrahlen. Dementsprechend kann das abgestrahlte Licht der lichtemittierenden Diode 80 in ungeschwächter Weise entweder von einem Benutzer oder aber von einem Photodetektor aufgenommen, entsprechend verarbeitet und interpretiert werden.

Fig. 5 zeigt das Leiterplattenelement 40 nach Fig. 4 in einer Seitenansicht. Deutlich ist die Unterteilung des Leiterplattenelements 40 in die drei Abschnitte erster Teilbereich 41, zweiter Teilbereich 42, und Verbindungsabschnitt 43 zu erkennen. Der in seiner Dicke deutlich verdünnte Verbindungsabschnitt 43 verbindet hierbei den oben angeordneten ersten Teilbereich 41 mit dem unten angeordneten zweiten Teilbereich 42, welche beide im Vergleich zum Verbindungsabschnitt 43 eine deutlich größere Dicke (Seitenausdehnung gemäß der Dartstellung) aufweisen. Hierbei umfassen die beiden Teilbereiche 41 und 42 jeweils insgesamt drei Materialschichten, deren rechts (entsprechend der vorliegenden Darstellung) angeordnete erste Schicht 71 zur Aufnahme der Schaltungselemente 56 sowie der lichtemittierenden Diode 80 dient. Darüber hinaus ist der Verbindungsabschnitt 43 derart ausgestaltet, dass er wenigstens einen Teil der ersten Schicht 71 umfasst. Die Dicke des Verbindungsabschnittes 43 kann hierbei mit der Dicke der ersten Schicht 71 übereinstimmen, oder jedoch auch dünner als diese sein. Die weiteren beiden Schichten des ersten sowie zweiten Teilbereiches 41 und 42 verleihen den Teilbereichen 41 und 42 sowohl Steifigkeit als auch Schutz vor unbeabsichtigter Beschädigung der Schaltungsanordnung 55 durch äußere mechanische Einflüsse. Die beiden Schichten, welche vorliegend zusammen die zweite Schicht 72 definieren, können ihrerseits weitere Unterschichten enthalten oder alternativ auch nur aus einer Schicht bestehen. Typische für die zweite Schicht 72 verwendete Stoffe sind Harze, Kunststoffe sowie alle isolierenden Materialien, welche eine hohe Materialsteifigkeit aufweisen.

Fig. 6 zeigt das in Fig. 5 bereits dargestellte Leiterplattenelement 40, wie es beispielsweise vorliegen würde, wenn es in der in Fig. 1 bis 3 dargestellten Tintenpatrone 10 eingesetzt ist. Der Verbindungsabschnitt 43, welcher in den Fig. 1 bis 3 in dem Bereich der Schrägung 33 angeordnet ist, weißt eine Rundung in Folge eines Biegevorganges auf. Hierbei sind die jeweils planen Teilbereiche 41 und 42 in Bezug aufeinander so orientiert, dass ihre seitlichen Begrenzungslinien weder parallel noch zueinander ausgefluchtet liegen, d.h. also die Flächenabschnitte der Teilbereiche 41 und 42 abgewinkelt zueinander ausgerichtet sind. Die in Fig. 6 dargestellte relative Orientierung des ersten Teilbereiches 41 zum zweiten Teilbereich 42 muss jedoch nicht auf Grundlage eines den Verbindungsabschnitt 43 betreffenden Biegevorganges resultieren, sondern kann alternativ auch in einem entsprechenden Herstellungsverfahren bereits dergestalt hergestellt sein. Die an die Flexibilität des Verbindungsabschnittes 43 gestellten Anforderungen können sich demnach entsprechend unterschiedlicher Konstruktionscharakteristika des Verbindungsabschnittes 43 vorliegend unterscheiden.

### Bezugszeichen:

- 10: Tintenpatrone
- 12: Seitenwand
- 13: Abschnitt
- 15: Arretierverschluss
- 16: Auffüllstutzen
- 17: Unterseite
- 18: Oberseite
- 19: Vorderwand

- 33: Schrägung

- 40: Leiterplattenelement
- 41: erster Teilbereich
- 42: zweiter Teilbereich
- 43: Verbindungsabschnitt

- 50: Befestigungselement
- 51: Laufschiene
- 52: Verriegelungshaken
- 53: Leiterbahnen
- 55: Schaltungsanordnung
- 56: Schaltungselement

- 61: Kontaktelement
- 65: Kontaktpunkt
- 66: Schnittstelle
- 71: erste Schicht
- 72: zweite Schicht

- 80: lichtemittierende Diode (LED)

Ebene A
Ebene B

## Patentansprüche

1. Tintenpatrone zum Einsetzen in eine Patronenaufnahme eines Tintenstrahldruckers, wobei die Tintenpatrone (10) ein eine Schaltungsanordnung (55) umfassendes Leiterplattenelement (40) aufweist, welches einen ersten in einer Ebene A liegenden Teilbereich (41) und einen gegenüber dem ersten Teilbereich (41) abgewinkelt ausgerichteten zweiten Teilbereich (42) aufweist,
**dadurch gekennzeichnet, dass**
das Leiterplattenelement (40) eine die Schaltungsanordnung (55) umfassende erste Schicht (71) und eine dem Leiterplattenelement (40) Festigkeit verleihende zweite Schicht (72) aufweist, wobei zwischen dem zweiten Teilbereich (42) und dem ersten Teilbereich (41) des Leiterplattenelements (40) ein Verbindungsabschnitt (43) vorgesehen ist, welcher einen Biegebereich des Leiterplattenelements (40) definiert, und in welchem die zweite Schicht (72) wenigstens verdünnt ist.

2. Tintenpatrone zum Einsetzen in eine Patronenaufnahme eines Tintenstrahldruckers nach Anspruch 1,
**dadurch gekennzeichnet, dass**
zumindest ein Teilbereich (41, 42) einer Außenkontur der Tintenpatrone (10) folgend an der Tintenpatrone befestigt ist.

3. Tintenpatrone zum Einsetzen in eine Patronenaufnahme eines Tintenstrahldruckers nach eine der vorhergehenden Ansprüche,
**dadurch gekennzeichnet, dass**
die Ebene A parallel zu mindestens einer Seitenwand (12), vorzugsweise zu einer Vor- und/oder Rückwand, ausgerichtet ist.

4. Tintenpatrone zum Einsetzen in eine Patronenaufnahme eines Tintenstrahldruckers nach einem der vorhergehenden Ansprüche,
**dadurch gekennzeichnet, dass**
der zweite Teilbereich (42) plan ausgebildet ist und in einer zweiten von der Ebene A verschiedenen Ebene B liegt.

5. Tintenpatrone zum Einsetzen in eine Patronenaufnahme eines Tintenstrahldruckers nach Anspruch 4,
**dadurch gekennzeichnet, dass**
die Ebene B parallel zu einem weiteren Abschnitt (13) der Außenbegrenzungsfläche der Tintenpatrone (10) ausgerichtet ist.

6. Tintenpatrone zum Einsetzen in eine Patronenaufnahme eines Tintenstrahldruckers nach einem der vorhergehenden Ansprüche,
**dadurch gekennzeichnet, dass**
die Tintenpatrone (10) Befestigungselemente (50) aufweist, mittels welcher das Leiterplattenelement (40) an der Tintenpatrone (10) befestigt ist.

7. Tintenpatrone zum Einsetzen in eine Patronenaufnahme eines Tintenstrahldruckers nach Anspruch 6,
**dadurch gekennzeichnet, dass**
die Befestigungselemente (50) eine Laufschiene (51), insbesondere an der mindestens einen Seitenwand (12), zum Einführen wenigstens eines Teiles des Leiterplattenelements (40) umfassen.

8. Tintenpatrone zum Einsetzen in eine Patronenaufnahme eines Tintenstrahldruckers nach ein der Ansprüche 6 oder 7,
**dadurch gekennzeichnet, dass**
die Befestigungselemente (50) einen elastisch verformbaren Verriegelungshacken (52) umfassen.

9. Tintenpatrone zum Einsetzen in eine Patronenaufnahme eines Tintenstrahldruckers nach einem der vorhergehenden Ansprüche,
**dadurch gekennzeichnet, dass**
das Leiterplattenelement (40) an der Tintenpatrone (10) lösbar angebracht ist.

10. Tintenpatrone zum Einsetzen in eine Patronenaufnahme eines Tintenstrahldruckers nach einem der Ansprüche 1 bis 9,
**dadurch gekennzeichnet, dass**
das Leiterplattenelement (40) an der Tintenpatrone (10) mittels Verklebung oder Laminierung oder Einschmelzung angebracht ist.

11. Leiterplattenelement zur Verbindung mit einer Tintenpatrone, nach einem der vorhergehenden Ansprüche, welche zum Einsetzen in eine Patronenaufnahme eines Tintenstrahldruckers vorgesehen ist, welches wenigstens eine Schaltungsanordnung (55) umfasst, wobei das Leiterplattenelement (40) wenigstens einen in einer Ebene A liegenden ersten Teilbereich (41) und einen gegenüber dem ersten Teilbereich (41) abgewinkelt ausgerichteten zweiten Teilbereich (42) aufweist,
**dadurch gekennzeichnet, dass**
das Leiterplattenelement (40) eine die Schaltungsanordnung (55) umfassende erste Schicht (71) und eine dem Leiterplattenelement (40) Festigkeit verleihende zweite Schicht (72) aufweist, wobei zwischen dem zweiten Teilbereich (42) und dem ersten Teilbereich (41) des Leiterplattenelements (40) ein Verbindungsabschnitt (43) vorgesehen ist, welcher einen Biegebereich des Leiterplattenelements (40) definiert, und in welchem die zweite Schicht (72) wenigstens verdünnt ist.

12. Leiterplattenelement zur Verbindung mit einer Tintenpatrone nach Anspruch 11,
**dadurch gekennzeichnet, dass**
der Verbindungsabschnitt (43) Leiterbahnen (53) umfasst.

13. Leiterplattenelement zur Verbindung mit einer Tintenpatrone nach einem der Ansprüche 11 oder 12,
**dadurch gekennzeichnet, dass**
der zweite Teilbereich (42) des Leiterplattenelements (40) Kontaktelemente (61) aufweist, welche bei in die Patronenaufnahme des Tintenstrahldruckers eingesetzter Tintenpatrone (10) mit entsprechenden Gegenkontaktelementen der Patronenaufnahme des Tintenstrahldruckers einen Kontakt schließen können.

14. Leiterplattenelement zur Verbindung mit einer Tintenpatrone nach einem der Ansprüche 11 bis 13,
**dadurch gekennzeichnet, dass**
die dem Leiterplattenelement (40) Festigkeit verleihende zweite Schicht (72) im Verbindungsabschnitt (43) entfernt ist.

15. Leiterplattenelement zur Verbindung mit einer Tintenpatrone nach einem der Ansprüche 11 bis 14,
**dadurch gekennzeichnet, dass**
das Leiterplattenelement (40) weitere Kontaktpunkte (65) aufweist, welche zur Kontaktierung mit einer externen elektrischen Schnittstelle (66) vorgesehen sind, über welche nach Herstellung eines elektrischen Kontaktes Informationen oder Signale zu der auf der ersten Schicht (71) angeordneten Schaltungsanordnung (55) gesendet oder mit dieser ausgetauscht werden können.

16. Leiterplattenelement zur Verbindung mit einer Tintenpatrone nach einem der Ansprüche 11 bis 15,
**dadurch gekennzeichnet, dass**
das Leiterplattenelement (40) wenigstens eine lichtemittierende Diode (LED) (80) aufweist.

17. Leiterplattenelement zur Verbindung mit einer Tintenpatrone nach einem der Ansprüche 11 bis 16,
**dadurch gekennzeichnet, dass**
die Kontaktelemente (61) im Wesentlichen endständig auf dem zweiten Teilbereich (42) des Leiterplattenelementes (40) angeordnet sind.

18. Leiterplattenelement zur Verbindung mit einer Tintenpatrone nach einem der Ansprüche 11 bis 17,
**dadurch gekennzeichnet, dass**
wenigstens eine lichtemittierende Diode (LED) (80) auf dem ersten Teilbereich (41) des Leiterplattenelementes (40) angeordnet ist.

19. Leiterplattenelement zur Verbindung mit einer Tintenpatrone nach einem der Ansprüche 11 bis 18,
**dadurch gekennzeichnet, dass**
wenigstens eine lichtemittierende Diode (LED) (80) im Wesentlichen endständig auf dem ersten Teilbereich (41) des Leiterplattenelementes (40) angeordnet ist.

20. Leiterplattenelement zur Verbindung mit einer Tintenpatrone nach einem der Ansprüche 11 bis 19,
**dadurch gekennzeichnet, dass**
wenigstens eine lichtemittierende Diode (LED) (80) auf dem Leiterplattenelement (40) derart angeordnet ist, dass das von der lichtemittierenden Diode (LED) (80) bei Aktivierung abgestrahlte Licht ungehindert von der Tintenpatrone (40), insbesondere senkrecht zu der Ebene A des Leiterplattenelementes (40), abgestrahlt wird.

21. Leiterplattenelement zur Verbindung mit einer Tintenpatrone nach einem der Ansprüche 11 bis 20,
**dadurch gekennzeichnet, dass**
die Schaltungsanordnung (55) des Leiterplattenelements (40) geeignet ist, die von einer externen Steuerung des Tintenstrahldruckers (10) über die Kontaktelemente (61) empfangenen Signale zu verarbeiten, und auf entsprechende Aufforderung eine Verifikationsroutine auszuführen, welche eine Verifikation der mit dem Leiterplattenelement (40) verbundenen Tintenpatrone (10) erlaubt.

22. Leiterplattenelement zur Verbindung mit einer Tintenpatrone nach Anspruch 21,
**dadurch gekennzeichnet, dass**
nach Durchlaufen der Verifikationsroutine, die Schaltungsanordnung (55) die Abgabe eines Lichtsignals durch die lichtemittierende Diode (LED) (80) auf dem Leiterplattenelement (40) erlaubt.

23. Leiterplattenelement zur Verbindung mit einer Tintenpatrone nach Anspruch 22,
**dadurch gekennzeichnet, dass**
nach Durchlaufen der Verifikationsroutine, die Schaltungsanordnung (55) die Abgabe eines Lichtsignals durch die lichtemittierende Diode (LED) (80) auf dem Leiterplattenelement (40) verhindert, falls das Ergebnis der Verifikationsroutine negativ ausgefallen ist.

24. Verfahren zur Herstellung einer Tintenpatrone zum Einsetzen in eine Patronenaufnahme eines Tintenstrahldruckers, aufweisend ein Leiterplattenelement (40) mit einer Schaltungsanordnung (55), welches einen ersten, in einer Ebene A liegenden Teilbereich (41) und einen gegenüber dem ersten Teilbereich (41) abgewinkelt ausgerichteten zweiten Teilbereich (42) aufweist, wobei das Leiterplattenelement (40) eine die Schaltungsanordnung (55) umfassende erste Schicht (71) und eine dem Leiterplattenelement (40) Festigkeit verleihende zweite Schicht (72) aufweist, und wobei zwischen dem zweiten Teilbereich (42) und dem ersten Teilbereich (41) des Leiterplattenelements (40) ein Verbindungsabschnitt (43) vorgesehen ist, welcher einen Biegebereich des Leiterplattenelements (40) definiert, und in welchem die zweite Schicht (72) wenigstens verdünnt ist, und folgende Schritte beinhaltet:
- Bereitstellen der Tintenpatrone (10)
- Bereitstellen des Leiterplattenelements (40)
- Anbringen des ersten Teilbereiches (41) des Leiterplattenelements (40) parallel zu mindestens einer Seitenwand, vorzugsweise zu einer Vor- und/oder Rückwand, der Tintenpatrone (10)
- Biegen des Verbindungsabschnitts (43) und Anbringen des zweiten Teilbereichs (42) an der Tintenpatrone (10).

## Claims

1. An ink cartridge for insertion into a cartridge receptacle of an inkjet printer,
wherein the ink cartridge (10) has a circuit board element (40) comprising a circuit arrangement (55), said circuit board element (40) having a first subarea (41) situated in a plane A and a second subarea (42) oriented at an angle with respect to the first subarea (41),
**characterized in that**
the circuit board element (40) has a first layer (71) comprising the circuit arrangement (55) and a second layer (72) imparting stability to the circuit board element (40), wherein between the second subarea (42) and the first subarea (41) of the circuit board element (40) a connecting section (43) is provided, which defines a flexible area of the circuit board element (40), and in which the second layer (72) is at least thinned.

2. The ink cartridge for insertion into a cartridge receptacle of an inkjet printer according to claim 1,
**characterized in that**
at least one subarea (41, 42) is attached to the ink cartridge following an outer contour of the ink cartridge (10).

3. The ink cartridge for insertion into a cartridge receptacle of an inkjet printer according to any one of the preceding claims,
**characterized in that**
the plane A is oriented parallel to at least one side wall (12), preferably to a front and/or rear wall.

4. The ink cartridge for insertion into a cartridge receptacle of an inkjet printer according to any one of the preceding claims,
**characterized in that**
the second subarea (42) is formed planar and is situated in a second plane B, which is different from plane A.

5. The ink cartridge for insertion into a cartridge receptacle of an inkjet printer according to claim 4,
**characterized in that**
the plane B is oriented parallell to a further section (13) of the outer boundary surface of the ink cartridge (10).

6. The ink cartridge for insertion into a cartridge receptacle of an inkjet printer according to any one of the preceding claims,
**characterized in that**
the ink cartridge (10) has fastening elements (50), by means of which the circuit board element (40) is attached to the ink cartridge (10).

7. The ink cartridge for insertion into a cartridge receptacle of an inkjet printer according to claim 6,
**characterized in that**
the fastening elements (50) comprise a guiding rail (51), in particular on the at least one side wall (12), for introducing at least a part of the circuit board element (40).

8. The ink cartridge for insertion into a cartridge receptacle of an inkjet printer according to one of claims 6 or 7,
**characterized in that**
the fastening elements (50) comprise an elastically deformable locking hook (52).

9. The ink cartridge for insertion into a cartridge receptacle of an inkjet printer according to any one of the preceding claims,
**characterized in that**
the circuit board element (40) is detachably mounted to the ink cartridge (10).

10. The ink cartridge for insertion into a cartridge receptacle of an inkjet printer according to any one of the claims 1 to 9,
**characterized in that**
the circuit board element (40) is mounted to the ink cartridge (10) by means of adhesion or lamination or fusion.

11. A circuit board element for connecting to an ink cartridge according to any one of the preceding claims, which is provided for insertion into a cartridge receptacle of an inkjet printer, said circuit board element (40) comprising at least one circuit arrangement (55), wherein the circuit board element (40) has at least one first subarea (41) situated in a plane A and a second subarea (42) oriented at an angle with respect to the first subarea (41),
**characterized in that**
the circuit board element (40) has a first layer (71) comprising the circuit arrangement (55) and a second layer (72) imparting stability to the circuit board element (40), wherein between the second subarea (42) and the first subarea (41) of the circuit board element (40) a connecting section (43) is provided, which defines a flexible area of the circuit board element (40), and in which the second layer (72) is at least thinned.

12. The circuit board element for connecting to an ink cartridge according to claim 11,
**characterized in that**
the connecting section (43) comprises conductor tracks (53).

13. The circuit board element for connecting to an ink cartridge according to any one of claims 11 or 12,
**characterized in that**
the second subarea (42) of the circuit board element (40) has contact elements (61) which are capable of coming into electrical contact with corresponding counter-contact elements of the cartridge receptacle of the inkjet printer when the ink cartridge (10) is inserted into the cartridge receptacle of the inkjet printer.

14. The circuit board element for connecting to an ink cartridge according to any one of claims 11 to 13,
**characterized in that**
the second layer (72) imparting stability to the circuit board element (40) is removed in the connecting section (43).

15. The circuit board element for connecting to an ink cartridge according to any one of claims 11 to 14,
**characterized in that**
the circuit board element (40) has further contact points (65) provided for contacting with an external electrical interface (66) via which, after an electrical contact has been established, information or signals may be transmitted to or exchanged with the circuit arrangement (55) disposed on the first layer (71).

16. The circuit board element for connecting to an ink cartridge according to any one of claims 11 to 15,
**characterized in that**
the circuit board element (40) has at least one light-emitting diode (LED) (80).

17. The circuit board element for connecting to an ink cartridge according to any one of claims 11 to 16,
**characterized in that**
the contact elements (61) are arranged essentially at an end position on the second subarea (42) of the circuit board element (40).

18. The circuit board element for connecting to an ink cartridge according to any one of claims 11 to 17,
**characterized in that**
at least one light-emitting diode (LED) (80) is arranged on the first subarea (41) of the circuit board element (40).

19. The circuit board element for connecting to an ink cartridge according to any one of claims 11 to 18,
**characterized in that**
at least one light-emitting diode (LED) (80) is arranged essentially at an end position on the first subarea (41) of the circuit board element (40)

20. The circuit board element for connecting to an ink cartridge according to any one of claims 11 to 19,
**characterized in that**
at least one light-emitting diode (LED) (80) is arranged on the circuit board element (40) such that the light radiated from the light-emitting diode (LED) (80) upon activation is radiated unimpeded from the ink cartridge (10), in particular perpendicular to the plane A of the circuit board element (40).

21. The circuit board element for connecting to an ink cartridge according to any one of claims 11 to 20,
**characterized in that**
the circuit arrangement (55) of the circuit board element (40) is suited to process the signals received from an external control of the inkjet printer (10) via the contact elements (61) and, upon a corresponding request, execute a verification routine which allows a verification of the ink cartridge (10) connected to the circuit board element (40).

22. The circuit board element for connecting to an ink cartridge according to claim 21,
**characterized in that**
after the verification routine has been run through, the circuit arrangement (55) allows the emission of a light signal by the light-emitting diode (LED) (80) on the circuit board element (40).

23. The circuit board element for connecting to an ink cartridge according to claim 22,
**characterized in that**
after the verification routine has been run through, the circuit arrangement (55) prevents the emission of a light signal by the light-emitting diode (LED) (80) on the circuit board element (40) if the result of the verification routine is negative.

24. A method for manufacturing an ink cartridge for insertion into a cartridge receptacle of an inkjet printer comprising a circuit board element (40) having a circuit arrangement (55) which has a first subarea (41) situated in a plane A, and a second subarea (42) oriented at an angle with respect to the first subarea (41), wherein the circuit board element (40) has a first layer (71) comprising the circuit arrangement (55) and a second layer (72) imparting stability to the circuit board element (40), and wherein between the second subarea (42) and the first subarea (41) of the circuit board element (40), a connecting section (43) is provided, which defines a flexible area of the circuit board element (40), and in which the second layer (72) is at least thinned, and wherein the method includes the following steps:
- providing the ink cartridge (10),
- providing the circuit board element (40),
- attaching the first subarea (41) of the circuit board element (40) parallel to at least one side wall, preferably to a front and/or rear wall of the ink cartridge (10),
- bending the connecting section (43) and attaching the second subarea (42) to the ink cartridge (10).

## Revendications

1. Cartouche d'encre à insérer dans un logement pour cartouche d'une imprimante à jet d'encre, la cartouche d'encre (10) présentant un élément de carte de circuit imprimé (40) comportant un agencement de circuits (55), et qui présente une première zone partielle (41) située dans un plan A et une deuxième zone partielle (42) dont l'orientation présente un angle par rapport à la première zone partielle (41),
**caractérisée en ce que**
l'élément de carte de circuit imprimé (40) présente une première couche (71) qui comporte l'agencement de circuits (55) et une deuxième couche (72) qui confère de la solidité à l'élément de carte de circuit imprimé (40), un segment de liaison (43) qui définit une zone de cintrage de l'élément de carte de circuit imprimé (40) et dans lequel la deuxième couche (72) est au moins amincie étant prévu entre la deuxième zone partielle (42) et la première zone partielle (41) de l'élément de carte de circuit imprimé (40).

2. Cartouche d'encre à insérer dans un logement pour cartouche d'une imprimante à jet d'encre selon la revendication 1,
**caractérisée en ce que**
au moins une zone partielle (41, 42) d'un contour extérieur de la cartouche d'encre (10) est fixée de manière consécutive à la cartouche d'encre.

3. Cartouche d'encre à insérer dans un logement pour cartouche d'une imprimante à jet d'encre selon l'une des revendications précédentes,
**caractérisée en ce que**
le plan A est orienté parallèlement à au moins une paroi latérale (12), de préférence à une paroi avant et/ou arrière.

4. Cartouche d'encre à insérer dans un logement pour cartouche d'une imprimante à jet d'encre selon l'une des revendications précédentes,
**caractérisée en ce que**
la deuxième zone partielle (42) est constituée de manière plane et située dans un deuxième plan B différent du plan A.

5. Cartouche d'encre à insérer dans un logement pour cartouche d'une imprimante à jet d'encre selon la revendication 4,
**caractérisée en ce que**
le plan B est orienté parallèlement à un segment supplémentaire (13) de la face de limitation extérieure de la cartouche d'encre (10).

6. Cartouche d'encre à insérer dans un logement pour cartouche d'une imprimante à jet d'encre selon l'une des revendications précédentes,
**caractérisée en ce que**
la cartouche d'encre (10) présente des éléments de fixation (50) au moyen desquels l'élément de carte de circuit imprimé (40) est fixé à la cartouche d'encre (10).

7. Cartouche d'encre à insérer dans un logement pour cartouche d'une imprimante à jet d'encre selon la revendication 6,
**caractérisée en ce que**
les éléments de fixation (50) comprennent un rail de roulement (51), en particulier sur l'au moins une paroi latérale (12), pour l'introduction d'au moins une partie de l'élément de carte de circuit imprimé (40).

8. Cartouche d'encre à insérer dans un logement pour cartouche d'une imprimante à jet d'encre selon l'une des revendications 6 ou 7,
**caractérisée en ce que**
les éléments de fixation (50) comprennent un crochet de verrouillage (52) déformable élastiquement.

9. Cartouche d'encre à insérer dans un logement pour cartouche d'une imprimante à jet d'encre selon l'une des revendications précédentes,
**caractérisée en ce que**
l'élément de carte de circuit imprimé (40) est apposé sur la cartouche d'encre (10) de manière détachable.

10. Cartouche d'encre à insérer dans un logement pour cartouche d'une imprimante à jet d'encre selon l'une des revendications 1 à 9,
**caractérisée en ce que**
l'élément de carte de circuit imprimé (40) est apposé sur la cartouche d'encre (10) par collage ou stratification ou fusion.

11. Élément de carte de circuit imprimé à relier à une cartouche d'encre, selon l'une des revendications précédentes, laquelle est prévue pour l'insertion dans un logement pour cartouche d'une imprimante à jet d'encre, qui comprend au moins un agencement de circuits (55), l'élément de carte de circuit imprimé (40) présentant au moins une première zone partielle (41) située dans un plan A et une deuxième zone partielle (42) dont l'orientation présente un angle par rapport à la première zone partielle (41),
**caractérisé en ce que**
l'élément de carte de circuit imprimé (40) présente une première couche (71) qui comporte l'agencement de circuits (55) et une deuxième couche (72) qui confère de la solidité à l'élément de carte de circuit imprimé (40), un segment de liaison (43) qui définit une zone de cintrage de l'élément de carte de circuit imprimé (40) et dans lequel la deuxième couche (72) est au moins amincie étant prévu entre la deuxième zone partielle (42) et la première zone partielle (41) de l'élément de carte de circuit imprimé (40).

12. Élément de carte de circuit imprimé à relier à une cartouche d'encre selon la revendication 11,
**caractérisé en ce que**
le segment de liaison (43) comprend des pistes conductrices (53).

13. Élément de carte de circuit imprimé à relier à une cartouche d'encre selon l'une des revendications 11 ou 12,
**caractérisé en ce que**
la deuxième zone partielle (42) de l'élément de carte de circuit imprimé (40) présente des éléments de contact (61), lesquels peuvent fermer un contact avec des contre-éléments de contact correspondants du logement pour cartouche de l'imprimante à jet d'encre lorsqu'une cartouche d'encre (10) est insérée dans le logement pour cartouche de l'imprimante à jet d'encre.

14. Élément de carte de circuit imprimé à relier à une cartouche d'encre selon l'une des revendications 11 à 13,
**caractérisé en ce que**
la deuxième couche (72) qui confère de la solidité à l'élément de carte de circuit imprimé (40) est ôtée dans le segment de liaison (43).

15. Élément de carte de circuit imprimé à relier à une cartouche d'encre selon l'une des revendications 11 à 14,
**caractérisé en ce que**
l'élément de carte de circuit imprimé (40) présente des points de contact supplémentaires (65), lesquels sont prévus pour la mise en contact avec une interface électrique externe (66) via laquelle, après établissement d'un contact électrique, des informations ou des signaux peuvent être envoyés à l'agencement de circuits (55) disposé sur la première couche (71) ou échangés avec celui-ci.

16. Élément de carte de circuit imprimé à relier à une cartouche d'encre selon l'une des revendications 11 à 15,
**caractérisé en ce que**
l'élément de carte de circuit imprimé (40) présente au moins une diode électroluminescente (LED) (80).

17. Élément de carte de circuit imprimé à relier à une cartouche d'encre selon l'une des revendications 11 à 16,
**caractérisé en ce que**
les éléments de contact (61) sont disposés de manière sensiblement terminale sur la deuxième zone partielle (42) de l'élément de carte de circuit imprimé (40).

18. Élément de carte de circuit imprimé à relier à une cartouche d'encre selon l'une des revendications 11 à 17,
**caractérisé en ce que**
au moins une diode électroluminescente (LED) (80) est disposée sur la première zone partielle (41) de l'élément de carte de circuit imprimé (40).

19. Élément de carte de circuit imprimé à relier à une cartouche d'encre selon l'une des revendications 11 à 18,
**caractérisé en ce que**
au moins une diode électroluminescente (LED) (80) est disposée de manière sensiblement terminale sur la première zone partielle (41) de l'élément de carte de circuit imprimé (40).

20. Élément de carte de circuit imprimé à relier à une cartouche d'encre selon l'une des revendications 11 à 19,
**caractérisé en ce que**
au moins une diode électroluminescente (LED) (80) est disposée sur l'élément de carte de circuit imprimé (40) de telle manière que la lumière émise par la diode électroluminescente (LED) (80) en cas d'activation soit émise sans entrave depuis la cartouche d'encre (10), en particulier perpendiculairement au plan A de l'élément de carte de circuit imprimé (40).

21. Élément de carte de circuit imprimé à relier à une cartouche d'encre selon l'une des revendications 11 à 20,
**caractérisé en ce que**
l'agencement de circuits (55) de l'élément de carte de circuit imprimé (40) est apte à traiter les signaux reçus depuis une commande externe de l'imprimante à jet d'encre (10) via les éléments de contact (61), et à exécuter, sur demande correspondante, une routine de vérification, laquelle autorise une vérification de la cartouche d'encre (10) reliée à l'élément de carte de circuit imprimé (40).

22. Élément de carte de circuit imprimé à relier à une cartouche d'encre selon la revendication 21,
**caractérisé en ce que**
après déroulement de la routine de vérification, l'agencement de circuits (55) autorise l'émission d'un signal lumineux par la diode électroluminescente (LED) (80) sur l'élément de carte de circuit imprimé (40).

23. Élément de carte de circuit imprimé à relier à une cartouche d'encre selon la revendication 22,
**caractérisé en ce que**
après déroulement de la routine de vérification, l'agencement de circuits (55) empêche l'émission d'un signal lumineux par la diode électroluminescente (LED) (80) sur l'élément de carte de circuit imprimé si le résultat de la routine de vérification s'est avéré négatif.

24. Procédé de fabrication d'une cartouche d'encre à insérer dans un logement pour cartouche d'une imprimante à jet d'encre, présentant un élément de carte de circuit imprimé (40) qui comporte un agencement de circuits (55), et qui présente une première zone partielle (41) située dans un plan A et une deuxième zone partielle (42) dont l'orientation présente un angle par rapport à la première zone partielle (41), l'élément de carte de circuit imprimé (40) présentant une première couche (71) qui comporte l'agencement de circuits (55) et une deuxième couche (72) qui confère de la solidité à l'élément de carte de circuit imprimé (40), et un segment de liaison (43) qui définit une zone de cintrage de l'élément de carte de circuit imprimé (40) et dans lequel la deuxième couche (72) est au moins amincie étant prévu entre la deuxième zone partielle (42) et la première zone partielle (41) de l'élément de carte de circuit imprimé (40), et comporte les étapes suivantes :
- mise à disposition de la cartouche d'encre (10)
- mise à disposition de l'élément de carte de circuit imprimé (40)
- apposition de la première zone partielle (41) de l'élément de carte de circuit imprimé (40) parallèlement à au moins une paroi latérale, de préférence à une paroi avant et/ou arrière, de la cartouche d'encre (10)
- cintrage du segment de liaison (43) et apposition de la deuxième zone partielle (42) sur la cartouche d'encre (10).
